# EUROPÄISCHE PATENTSCHRIFT

(11) **EP 1 142 017 B1**
(45) Veröffentlichungstag und Bekanntmachung des Hinweises auf die Patenterteilung: **23.04.2008**
(21) Anmeldenummer: 99963216.9
(22) Anmeldetag: 11.11.1999
(51) Int. Cl.: H01L 27/02

(54) **VERFAHREN ZUR HERSTELLUNG EINES HALBLEITERBAUELEMENTS MIT EINER STÜCKWEISE IM SUBSTRAT VERLAUFENDEN VERDRAHTUNG**
METHOD FOR PRODUCING A SEMICONDUCTOR COMPONENT WITH WIRING PARTLY EXTENDING IN THE SUBSTRATE
PROCEDE DE FABRICATION D'UN COMPOSANT SEMI-CONDUCTEUR A CABLAGE S'ETENDANT PAR PORTIONS DANS LE SUBSTRAT

(30) Priorität: 11.11.1998 DE 19852072
(43) Veröffentlichungstag der Anmeldung: 10.10.2001
(73) Patentinhaber: Infineon Technologies AG, 81669 München (DE)
(72) Erfinder: BRAUN, Helga, D-81545 München (DE); KAKOSCHKE, Ronald, D-81475 München (DE); STOKAN, Regina, D-81373 München (DE); PLASA, Gunther, 9500 Villach (AT); KUX, Andreas, D-85540 Haar (DE)
(74) Vertreter: Epping - Hermann - Fischer
(86) Internationale Anmeldenummer: PCT/DE1999/003603
(87) Internationale Veröffentlichungsnummer: WO 2000/028593

(56) Entgegenhaltungen:
- EP-A- 0 585 601
- EP-A- 0 764 985
- DE-A- 1 614 250
- US-A- 4 583 011
- PATENT ABSTRACTS OF JAPAN vol. 012, no. 385 (E-668), 14. Oktober 1988 (1988-10-14) -& JP 63 129647 A (FUJITSU LTD), 2. Juni 1988 (1988-06-02)
- PATENT ABSTRACTS OF JAPAN vol. 014, no. 550 (E-1009), 6. Dezember 1990 (1990-12-06) -& JP 02 237038 A (RICOH CO LTD), 19. September 1990 (1990-09-19)

## Beschreibung

Die Erfindung betrifft ein Verfahren zur Herstellung eines Halbleiterbauelements mit einer stückweise im Substrat verlaufenden Verdrahtung. Halbleiterbauelemente mit teilweise im Substrat verlaufenden Verdrahtungen sind beispielsweise aus der DE 35 02 713 A1 und aus der DE-AS 16 14 250 bekannt.

Integrierte Schaltkreise, insbesondere CMOS-Schaltkreise, werden mit einer Vielzahl von Prozeßschritten hergestellt. Die Herstellungskosten dieser Schaltkreise werden dabei durch die Prozeßkomplexität und die physikalische Bearbeitungszeit bestimmt. Hochkomplexe Bausteine erfordern häufig mehrere hundert einzelne Prozeßschritte und eine Vielzahl von Tagen für den Prozessdurchlauf des Produkts.

Ein Teil der Prozeßschritte muß dabei für die Erzeugung der Verdrahtung aufgewendet werden, welche die einzelnen aktiven Bauelementen miteinander verbindet bzw. den Anschluß der integrierten Schaltung an die "Außenwelt" sicher stellt. Üblicherweise wird derartige Verbindungen durch eine oder mehrere Leiterbahnebenen aus Aluminium realisiert.

Es gibt jedoch Anwendungen, bei denen eine Leiterbahnebene aus Aluminium zum einen zu teuer ist und zum anderen einen zu hohen Platzbedarf aufweist. Darüber hinaus sind integrierte Schaltungen, die mit einer Aluminium-Verdrahtung realisiert sind, nicht ausreichend gegen externe Manipulation oder die nachträgliche Analyse einer Schaltung geschützt.

Die EP 0 764 985 A2 beschreibt eine Schaltung mit einer vorgetäuschten Verschaltung durch Zwischenverbindungen, die aber nach außen nicht sichtbar durch Kanalstoppgebiete unterbrochen sind.
Um Manipulationen an einer integrierten Schaltung vornehmen zu können, muß in der Regel zuerst die integrierte Schaltung analysiert werden. Dazu müssen Schicht für Schicht die Passivierungsschicht bzw. die Isolationschichten zwischen den Verdrahtungsebenen abgelöst werden, damit die so freigelegten Verdrahtungsebenen untersucht werden können. Liegen dabei die Verdrahungsebenen als Aluminuim-Verdrahtung vor, so kann eine derartige Schaltungsanalyse relativ einfach durchgeführt werden.

Der Erfindung liegt daher die Aufgabe zugrunde, ein Verfahren zur Herstellung eines Halbleiterbauelements mit einer stückweise im Substrat verlaufenden Verdrahtung anzugeben, bei dem die Analyse der integrierten Schaltung sowie deren nachträgliche Manipulation deutlich erschwert sind.

Weiterhin sollte das Verfahren zur Erzeugung einer derartigen Verdrahtung möglichst gut an das Verfahren zur Herstellung der Transistoren angepaßt sein und möglichst wenige zusätzliche Prozeßschritte erfordern.

Diese Aufgabe wird von dem Verfahren gemäß Patentanspruch 1 gelöst. Weitere vorteilhafte Ausführungsformen, Ausgestaltungen und Aspekte der vorliegenden Erfindung ergeben sich aus den Unteransprüchen, der Beschreibung und den beiliegenden Zeichnungen.

Erfindungsgemäß wird ein Verfahren zur Herstellung eines Halbleiterbauelements mit einer zumindest stückweise im Substrat verlaufenden Verdrahtung, wobei zumindest eine im Halbleitersubstrat verlaufende, leitende Verbindung und zumindest eine auf dem Halbleitersubstrat verlaufende, leitende Verbindung vorgesehen sind, bereitgestellt. Das erfindungsgemäße Verfahren umfaßt die Schritte:
a) ein Halbleitersubstrat wird bereitgestellt, das zumindest zwei Gebiete aufweist, wobei in einem ersten Gebiet die Transistoren des ersten Transistortyps und in einem zweiten Gebiet die Transistoren des zweiten Transistortyps angeordnet werden,
b) auf das Halbleitersubstrat wird eine erste isolierende Schicht aufgebracht,
c) ein Dotierstoff eines ersten Leitfähigkeitstyps wird in das erste Gebiet in den Bereich eines späteren Kreuzungspunktes zwischen der im Halbleitersubstrat verlaufenden, leitenden Verbindung und der auf dem Halbleitersubstrat verlaufenden, leitenden Verbindung eingebracht und/oder ein Dotierstoff eines zweiten Leitfähigkeitstyps wird in das zweite Gebiet in den Bereich eines späteren Kreuzungspunktes zwischen der im Halbleitersubstrat verlaufenden, leitenden Verbindung und der auf dem Halbleitersubstrat verlaufenden, leitenden Verbindung eingebracht,
d) auf die erste isolierende Schicht wird eine leitende Schicht aufgebracht,
e) mittels einer Phototechnik wird eine erste Maske aufgebracht, welche in dem ersten Gebiet im wesentlichen nur die Gatebahnen der zu erzeugenden Transistoren des ersten Transistortyps sowie gegebenenfalls die auf dem Halbleitersubstrat verlaufende, leitende Verbindung und das zweite Gebiet nahezu vollständig bedeckt,
f) entsprechend dieser ersten Maske werden die leitende Schicht in eine zweite Isolationschicht umgewandelt oder entfernt und zumindest ein Dotierstoff eines ersten Leitfähigkeitstyps in das Halbleitersubstrat eingebracht,
g) mittels einer Phototechnik wird eine zweite Maske aufgebracht, welche in dem zweiten Gebiet im wesentlichen nur die Gatebahnen der zu erzeugenden Transistoren des zweiten Transistortyps sowie gegebenenfalls die auf dem Halbleitersubstrat verlaufende, leitende Verbindung und das erste Gebiet nahezu vollständig bedeckt,
h) entsprechend dieser zweiten Maske werden die leitende Schicht in eine zweite Isolationschicht umgewandelt oder entfernt und zumindest ein Dotierstoff eines zweiten Leitfähigkeitstyps in das Halbleitersubstrat eingebracht,
i) durch eine Erhöhung der Temperatur wird durch die im Bereich der Kreuzungspunkte und die mittels der ersten bzw. zweiten Maske eingebrachten Dotierstoffe eine im Halbleitersubstrat verlaufende, leitende Verbindung erzeugt.

Die Verfahrensschritte müssen nicht notwendigerweise in der angegebenen Reihefolge durchgeführt werden, insbesondere können die Verfahrensschritte b) und c) auch in ihrer Reihenfolge vertauscht werden. Mit dem so hergestellten Halbleiterbauelement können niederohmige Unterführungen unterhalb der Gate-Ebene realisiert werden, wodurch eine nachträgliche Schaltungs-Analyse deutlich erschwert wird. Das Halbleiterbauelement ermöglicht somit Anwendungen, bei denen es auf eine hohe Sicherheit gegen externe Manipulationen ankommt.

Das erfindungsgemäße Verfahren besitzt darüber hinaus den Vorteil, daß es zur Erzeugung von zumindest zwei Transistortypen, beispielsweise PMOS- und NMOS-Transistoren, sowie der im Substrat verlaufenden Verdrahtung nur drei Photoebenen benötigt, während die herkömmlichen Herstellungsverfahren üblicherweise 6 oder mehr Photoebenen benötigen. Bei dem erfindungsgemäßen Verfahren dienen die mittels der Phototechnik erzeugten Masken, in dem jeweiligen Gebiet, sowohl zur Strukturierung der Gatebahnen bzw. der auf dem Substrat verlaufenden Verbindungen als auch zur Einbringung des Dotierstoffs, um die Source/Drain-Gebiete bzw. die im Substrat verlaufenden Verbindungen zu erzeugen. Durch die Einsparung von drei Photoebenen wird der Prozeßablauf wiederum deutlich vereinfacht und beschleunigt, so daß sich eine kostengünstige Produktion gewährleisten läßt. Derartige integrierte Schaltungen können somit ebenfalls in Anwendungen eingesetzt werden, bei denen es insbesondere auf geringe Herstellungskosten ankommt.

Bei dem erfindungsgemäßen Verfahren ist es insbesondere bevorzugt, wenn zwischen dem ersten und zweiten Gebiet ein Bereich (bzw. Bereiche) vorgesehen ist, der von beiden Masken nicht bedeckt wird. Auf diese Weise ist sichergestellt, daß in der Ebene der leitenden Schicht nur die wirklich vorgesehenen Verbindungen eine leitende Verbindung zwischen ersten und dem zweiten Gebiet herstellen.

Weiterhin ist es bevorzugt, wenn auf die leitende Schicht eine Schutzschicht, insbesondere eine Oxid-Nitrid-Oxid-Schicht, aufgebracht wird, die nach dem Aufbringen der Masken entsprechend den Masken entfernt wird.

Ebenso ist es bevorzugt, wenn die leitende Schicht eine Polysiliziumschicht ist.

Gemäß einer Ausführungsform der vorliegenden Erfindung wird die Polysiliziumschicht durch Oxidation in die zweite isolierende Schicht umgewandelt. Dabei ist es insbesondere bevorzugt, wenn die Polysiliziumschicht in die zweite isolierende Schicht umgewandelt wird, indem ein Teil der Polysiliziumschicht entfernt und der verbleibende Teil durch Oxidation in eine Siliziumoxidschicht umgewandelt wird.

Weiterhin ist es bevorzugt, wenn der Dotierstoff durch eine Implantation mit anschließender Wärmebehandlung in das Halbleitersubstrat eingebracht wird. Dabei kann insbesondere die bei Oxidation der Polysiliziumschicht auftretende erhöhte Prozeßtemperatur zum Eintreiben des Dotierstoffs verwendet werden.

Darüber hinaus ist es bevorzugt, wenn
das erste und das zweite Gebiet jeweils Bereiche aufweisen, die für Substratkontakte vorgesehen sind,
die erste Maske über den Bereichen in dem zweiten Gebiet, die für Substratkontakte vorgesehen sind, Öffnungen aufweist und Bereiche in dem ersten Gebiet, die für Substratkontakte vorgesehen sind, bedeckt,
und wenn die zweite Maske über den Bereichen in dem ersten Gebiet, die für Substratkontakte vorgesehen sind, Öffnungen aufweist und Bereiche in dem zweiten Gebiet, die für Substratkontakte vorgesehen sind, bedeckt.

Weiterhin ist bevorzugt, wenn in den vorgegebenen Gebieten, in denen die zu erzeugenden Transistoren angeordnet werden sollen, Isolationszonen, insbesondere Locos-Isolationen oder Shallow-Trench-Isolationen, vorgesehen sind, die die Transistoren begrenzen.

Die Erfindung wird nachfolgend anhand von Figuren der Zeichnung näher dargestellt. Es zeigen:
Figuren 1 bis 5 schematische Querschnitte durch verschiedene Stadien eines erfindungsgemäßen Verfahrens, und
Figuren 6 und 7 je eine Aufsicht auf die in Fig. 4 im Querschnitt gezeigte Struktur.

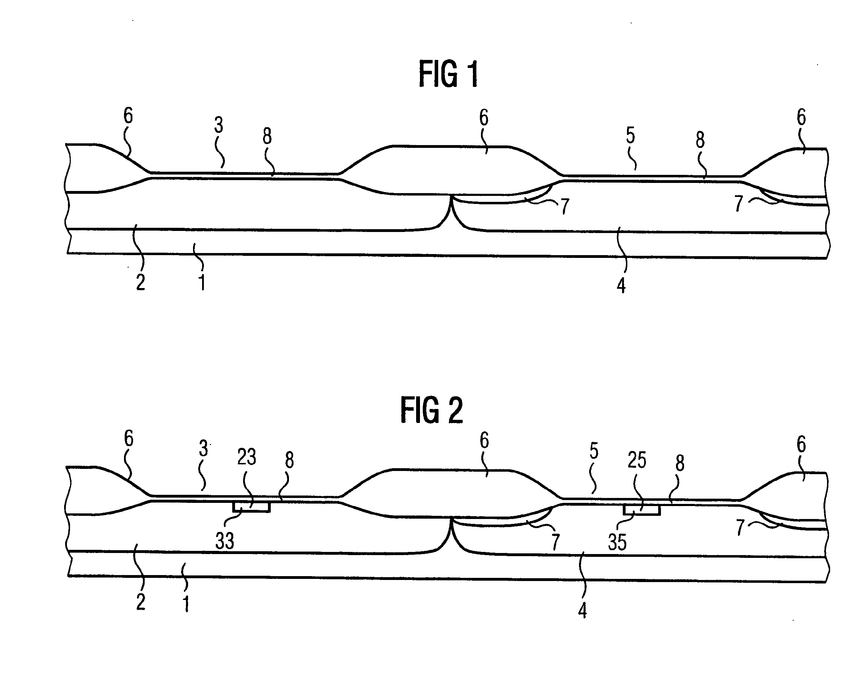

Fig. 1 zeigt das Halbleitersubstrat 1, das als Ausgangspunkt für das erfindungsgemäße Verfahren bereitgestellt wird. In dem p-leitenden Halbleitersubstrat 1 ist eine n-leitende Wanne 2 vorgesehen. Die Ausdehnung der n-Wanne 2 definiert somit eines der Gebiete 3, die später eine p-Diffusion als leitende Verbindung aufnimmt. Weiterhin ist in dem Halbleitersubstrat 1 eine p-leitende Wanne 4 vorgesehen. Die Ausdehnung der p-Wanne 4 definiert somit ebenfalls eines der Gebiete 5, die später eine n-Diffusion als leitende Verbindung aufnimmt.

Darüber hinaus sind Locos-Isolationen 6 vorgesehen, die einzelne Verbindungen gegeneinander lateral isolieren. Zur Verbesserung der Isolation können dabei unterhalb der Locos-Isolationen noch Feldimplantationen 7 vorhanden sein.

Auf dieses so vorstrukturierte Halbleitersubstrat 1 wurde eine Oxidschicht 8 als Isolationsschicht zwischen den Locos-Isolationen auf das Halbleitersubstrat 1 aufgebracht. Diese Oxidschicht 8 dient im folgenden in anderen Bereichen des Halbleitersubstrats 1 als Gateoxid für die noch zu erzeugenden Transistoren (nicht gezeigt). Die sich daraus ergebende Struktur ist in Figur 1 gezeigt.

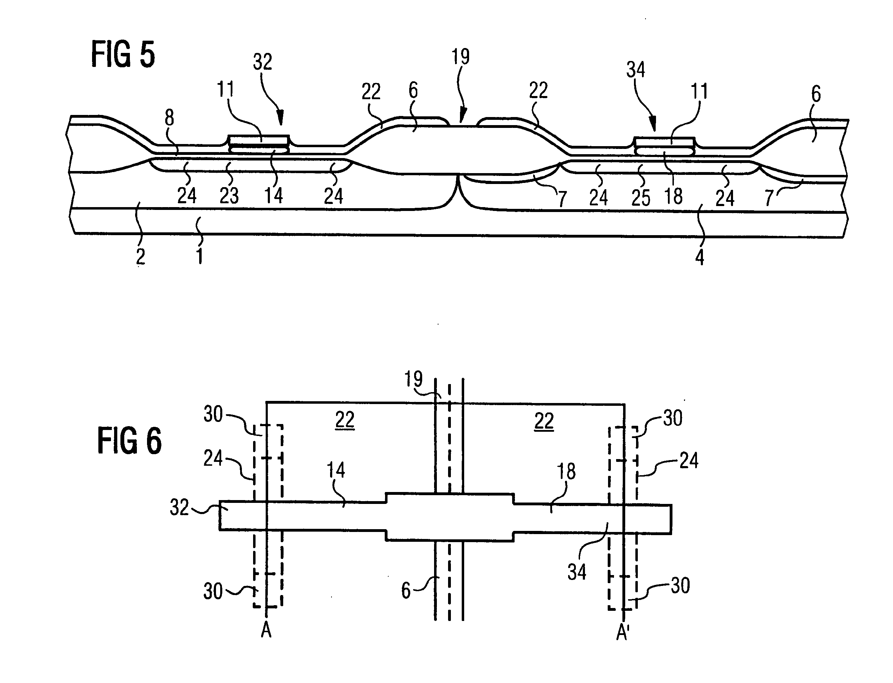

Mittels einer Phototechnik werden nun Boratome 33 in die n-leitende Wanne 2 des Halbleitersubstrats 1 implantiert (Implantationsenergie 20 keV, Implantationsdosis 2*10¹⁴ cm⁻²). Dabei werden die Boratome in einen Bereich 23 implantiert, der später den Kreuzungspunkt zwischen der im Halbleitersubstrat verlaufenden, leitenden Verbindung 24 und auf dem Halbleitersubstrat verlaufenden, leitenden Verbindung 14 (siehe Fig. 6) bilden wird.

Mittels einer weiteren Phototechnik werden Phosphoratome 35 in die p-leitende Wanne 4 des Halbleitersubstrats 1 implantiert (Implantationsenergie 20 keV, Implantationsdosis 2*10¹⁴ cm⁻²). Dabei werden die Phosphoratome in einen Bereich 25 implantiert, der später den Kreuzungspunkt zwischen der im Halbleitersubstrat verlaufenden, leitenden Verbindung 24 und die auf dem Halbleitersubstrat verlaufenden, leitenden Verbindung 18 (siehe Fig. 6) bilden wird. Die sich daraus ergebende Situation ist in Fig. 2 gezeigt.

Anschließend wird durch CVD-Abscheidung eine Polysiliziumschicht 10 als leitende Schicht auf die Oxidschicht 8 und die Locos-Isolation 6 aufgebracht. Dabei besitzt die Polysiliziumschicht 10 beispielsweise eine Dicke von 150 nm und eine n⁺-Dotierung von 2.0 10²⁰ cm⁻³. Diese Dotierung kann insitu während der Abscheidung, durch nachträgliche Implantation oder eine sogenannte POCL-Belegung erfolgen. Es folgt die Abscheidung einer Oxid-Nitrid-Schicht auf die Polysiliziumschicht 10, wobei aus der Oxid-Nitrid-Schicht nachfolgend durch Oxidation eine Oxid-Nitrid-Oxid-Schicht 11 als Schutzschicht entsteht.

Mittels einer Phototechnik wird nun eine erste Maske 12 auf die Oxid-Nitrid-Oxid-Schicht 11 aufgebracht. Dabei bedeckt die erste Maske 12 über der n-Wanne 2 im wesentlichen nur die Verbindung 14 , während die p-Wanne 4 nahezu vollständig zugedeckt wird.

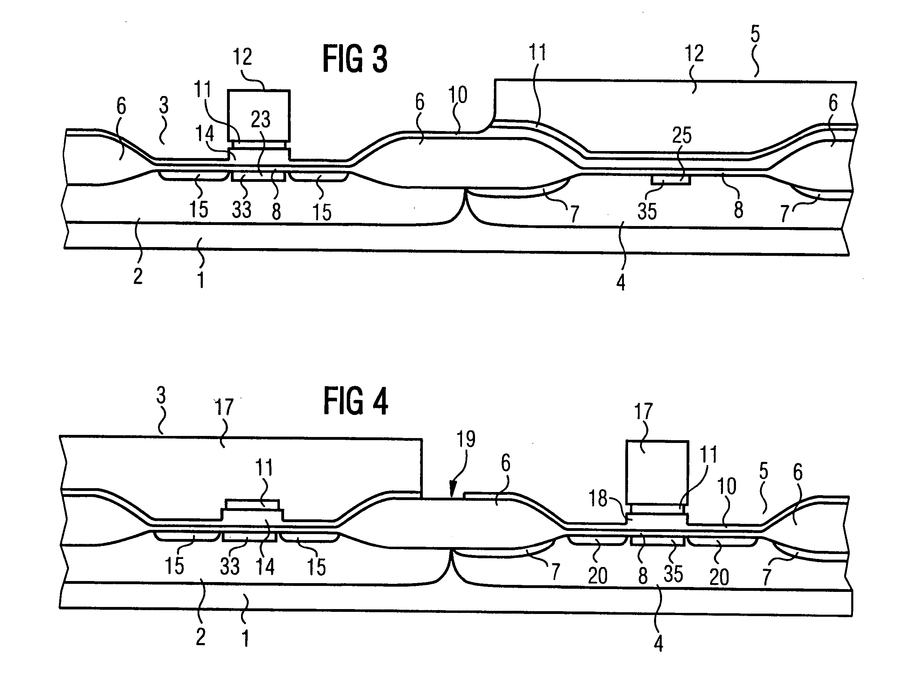

Über dem Bereich 19 (siehe Fig. 4) zwischen den beiden Wannen 2 und 4 ist die Maske 12 etwas zurückgezogen, so daß auch dieser Bereich freibleibt.

Entsprechend dieser ersten Maske 12 werden die freiliegenden Teile der Oxid-Nitrid-Oxid-Schicht 11 durch eine Ätzung entfernt. Weiterhin wird entsprechend dieser ersten Maske 12 der freiliegende Teil der Polysiliziumschicht 10 bis zu einer vorgegebenen Dicke entfernt. Und schließlich werden entsprechend dieser ersten Maske 12 Boratome 15 in das Halbleitersubstrat 1 und die Locos-Isolation 6 implantiert (Implantationsenergie 20 keV, Implantationsdosis 2*10¹⁵ cm⁻²). Da die in die Locos-Isolation 6 implantierten Bor-Atome im weiteren keine Rolle spielen, sind nur die in das Halbleitersubstrat 1 implantierten Boratome in der Fig. 3 gezeigt.

Dabei könnte die Maske 12 bereits nach der Strukturierung der Schutzschicht 11 oder nach der Strukturierung der leitenden Schicht 10 entfernt werden, es ist jedoch bevorzugt, die Maske 12 solange zu belassen, bis die Dotierstoffimplantation abgeschlossen ist. Auf diese Weise kann eine relativ dünne leitende Schicht verwendet werden, die nur geringe Topologieunterschiede auf der Substratoberfläche nach sich zieht.

Ist die Bor-Implantation abgeschlossen, wird die erste Maske 12 entfernt, und mittels einer weiteren Phototechnik wird eine zweite Maske 17 aufgebracht. Dabei bedeckt die zweite Maske 17 über der p-Wanne 4 nur die Verbindung 18, während die n-Wanne 2 nahezu vollständig zugedeckt wird.

Über dem Bereich 19 (siehe Fig. 4) zwischen den beiden Wannen 2 und 4 ist die Maske 17 etwas zurückgezogen, so daß auch dieser Bereich freibleibt.

Entsprechend dieser zweiten Maske 17 werden die noch vorhandenen, jetzt freiliegenden Teile der Oxid-Nitrid-Oxid-Schicht 11 durch eine Ätzung entfernt. Weiterhin wird entsprechend dieser zweiten Maske 17 der noch vorhandene, freiliegende Teil der Polysiliziumschicht 10 bis zu einer vorgegebenen Dicke entfernt. Dies führt unter anderem dazu, daß in einem Bereich 19 zwischen dem ersten und dem zweiten Gebiet, der von beiden Masken nicht bedeckt wurde, die Polysiliziumschicht 10 vollständig entfernt wird.

Schließlich werden entsprechend dieser zweiten Maske 17 Phosphor- und/oder Arsenatome 20 in das Halbleitersubstrat 1 und die Locos-Isolation 6 implantiert (Phosphor: Implantationsenergie 130 keV, Implantationsdosis 1*10¹⁴ cm⁻² ; Arsen: Implantationsenergie 150 keV, Implantationsdosis 2*10¹⁵ cm⁻²). Da die in die Locos-Isolation 6 implantierten Dotierstoffatome im weiteren keine Rolle spielen, sind nur die in das Halbleitersubstrat 1 implantierten Dotierstoffatome in der Fig. 4 gezeigt.

Ist die Phosphor/Arsen-Implantation abgeschlossen wird die zweite Maske 17 entfernt und es folgt eine Oxidation des noch verbliebenen und nicht von einer Schutzschicht 11 geschützten Polysiliziums 10, so daß eine Oxidschicht 22 als zweite Isolationschicht entsteht. Die mit der Oxid-Nitrid-Oxid-Schicht 11 abgedeckten Verbindungen 14, 18 werden dabei nicht oxidiert. Die Oxidation der Polysiliziumschicht 10 findet beispielsweise in feuchter Atmosphäre bei einer Temperatur von etwa 950°C für 80 min statt. Diese erhöhte Temperatur wird gleichzeitig dazu genutzt, die Dotierstoffe Bor bzw. Phosphor/Arsen in das Halbleitersubstrat einzutreiben, um so die im Halbleitersubstrat verlaufenden, leitenden Verbindungen 24 zu erzeugen.

Die Konzentration der Dotierstoffe ist dabei so gewählt, daß die im Halbleitersubstrat verlaufenden, leitenden Verbindungen 24 in den Bereichen 23, 25 der Kreuzungspunkte 32, 34 eine ausreichende Leitfähigkeit besitzen. Dies verhindert, daß sich an den Kreuzungspunkten 32, 34 Transistoren bilden. Die daraus ergebende Situation ist in Fig. 5 gezeigt.

Gemäß einer weiteren Ausführungsform des erfindungsgemäßen Verfahrens, wird die Polysiliziumschicht 10 während des Ätzens nicht nur bis zu einer vorgegebenen Dicke sondern vollständig entfernt. Dies hat zur Folge, daß ein langer Oxidationschritt zur Umwandlung des verbliebenen Polysiliziums nicht mehr notwendig ist. In diesem Fall wird nur eine relativ kurze Wärmebehandlung durchgeführt, um die Dotierstoffe in das Halbleitersubstrat einzutreiben (950°C für etwa 20 min).

Fig. 6 zeigt eine Aufsicht auf die in Fig. 5 im Querschnitt gezeigte Struktur. Die in Fig. 5 gezeigte Struktur ergibt sich durch einen Schnitt entlang der Linie A A' in Figur 6 und nachfolgendem Aufklappen.

Man erkennt, daß die Gatebahnen 14 und 18 eine auf dem Halbleitersubstrat 1 verlaufende, leitende Verbindung darstellen, die beispielsweise die Gate-Elektroden zweier Transistoren (nicht gezeigt) miteinander verbindet. Hingegen stellen die Diffusionsgebiete 24, die in einem späteren Verfahrensschritt durch Kontaktlöcher an Stellen 30 kontaktiert werden, die im Halbleitersubstrat 1 verlaufende, leitende Verbindung dar.

Unternimmt nun jemand den Versuch eine so hergestellte, integrierte Schaltung zu analysieren, erscheint ihm die in Fig. 6 in Aufsicht gezeigte Verdrahtung als eine Anordnung zweier Transistoren in einer CMOS-Technologie. Der Unterschied ergibt sich nur durch die Dotierungskonzentration in den Bereichen 23 und 25. Diese Dotierungskonzentration ist jedoch nachträglich nur mit sehr großem Aufwand festzustellen. Daher wird eine nachträgliche Schaltungsanalyse nicht zu der korrekten Schaltung führen. Daher ist auch die nachträgliche Manipulation der integrierten Schaltung deutlich erschwert.

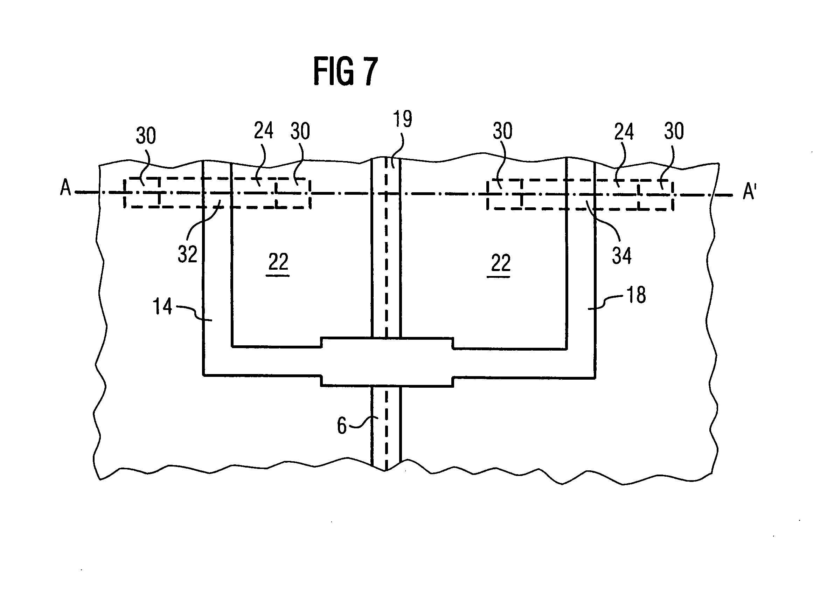

Figur 7 zeigt ebenfalls in Aufsicht eine Anordnung, bei der die Diffusionsgebiet 24 auf einer Linie liegen. Die Linie A A' ist hier im Gegensatz zur Figur 6 gestreckt. Dagegen sind die Gatebahnen 14, 18 zueinander winklig angeordnet.

Anschließend folgt eine Abscheidung einer weiteren Isolationschicht, beispielsweise BPSG, und einer weiteren leitenden Schicht, beispielsweise Aluminium, um eine erste Metallisierungsebene zu bilden. Je nach Komplexität der herzustellenden Schaltung können weitere Isolationsschichten und weitere leitende Schichten aufgebracht werden. Für einfache Schaltungen ist eine Metallisierungsebene jedoch in Regel ausreichend, so daß nun eine Passivierungsschicht abgeschieden werden kann.

## Patentansprüche

1. Verfahren zur Herstellung eines Halbleiterbauelements mit einer zumindest stückweise im Substrat verlaufenden Verdrahtung, wobei zumindest eine im Halbleitersubstrat verlaufende, leitende Verbindung (24) und zumindest eine auf dem Halbleitersubstrat (1) verlaufende, leitende Verbindung (14, 18) vorgesehen sind und das Verfahren an ein Verfahren zur Herstellung von zumindest zwei MOS-Transistortypen angepaßt ist, mit den folgenden Schritten:
a) ein Halbleitersubstrat (1) wird bereitgestellt, das zumindest ein erstes Gebiet (3) eines zweiten Leitfähigkeitstyps für die Transistoren des ersten Transistortyps und ein zweites Gebiet (5) eines ersten Leitfähigkeitstyps für die Transistoren des zweiten Transistortyps aufweist,
b) auf das Halbleitersubstrat (1) wird eine erste isolierende Schicht (8) aufgebracht,
c) ein Dotierstoff des ersten Leitfähigkeitstyps wird in das erste Gebiet (3) in den Bereich eines späteren Kreuzungspunktes zwischen der im Halbleitersubstrat verlaufenden, leitenden Verbindung (24) und der auf dem Halbleitersubstrat (1) verlaufenden, leitenden Verbindung (14) eingebracht und/oder ein Dotierstoff des zweiten Leitfähigkeitstyps wird in das zweite Gebiet (5) in den Bereich eines späteren Kreuzungspunktes zwischen der im Halbleitersubstrat verlaufenden, leitenden Verbindung (24) und der auf dem Halbleitersubstrat (1) verlaufenden, leitenden Verbindung (18) eingebracht,
d) auf die erste isolierende Schicht (8) wird eine leitende Schicht (10) aufgebracht,
e) mittels einer Phototechnik wird eine erste Maske (12) aufgebracht, welche das zweite Gebiet (5) nahezu vollständig und in dem ersten Gebiet (3) im wesentlichen nur die Gatebahnen der zu erzeugenden Transistoren des ersten Transistortyps sowie gegebenenfalls die auf dem Halbleitersubstrat (1) verlaufende, leitende Verbindung (14) bedeckt,
f) diese erste Maske (12) wird verwendet, um die leitende Schicht (10) in eine zweite Isolationschicht (22) umzuwandeln oder zu entfernen und zumindest einen Dotierstoff (15) des ersten Leitfähigkeitstyps in das Halbleitersubstrat (1) einzubringen,
g) mittels einer Phototechnik wird eine zweite Maske (17) aufgebracht, welche das erste Gebiet (3) nahezu vollständig und in dem zweiten Gebiet (5) im wesentlichen nur die Gatebahnen der zu erzeugenden Transistoren des zweiten Transistortyps sowie gegebenenfalls die auf dem Halbleitersubstrat (1) verlaufende, leitende Verbindung (18) bedeckt,
h) diese zweite Maske (17) wird verwendet, um die leitende Schicht (10) in eine zweite Isolationschicht (22) umzuwandeln oder zu entfernen und zumindest einen Dotierstoff (20) des zweiten Leitfähigkeitstyps in das Halbleitersubstrat (1) einzubringen,
i) durch eine Erhöhung der Temperatur wird durch die im Bereich der Kreuzungspunkte und die mittels der ersten bzw. zweiten Maske eingebrachten Dotierstoffe eine im Halbleitersubstrat verlaufende, leitende Verbindung (24) erzeugt.

2. Verfahren nach Anspruch 1,
**dadurch gekennzeichnet , daß**
das zwischen dem ersten und zweiten Gebiet (3, 5) ein Bereich (19) vorgesehen ist, der von beiden Masken (12, 17) nicht bedeckt wird.

3. Verfahren nach einem der Ansprüche 1 oder 2,
**dadurch gekennzeichnet, daß**
auf die leitende Schicht (10) eine Schutzschicht (11) aufgebracht wird, die nach dem Aufbringen der Maske(n) (12, 17) entsprechend der (den) Maske(n) (12, 17) entfernt wird.

4. Verfahren nach Anspruch 3,
**dadurch gekennzeichnet, daß**
die Schutzschicht (11) eine Oxid-Nitrid-Oxid-Schicht ist.

5. Verfahren nach einem der Ansprüche 1 bis 4,
**dadurch gekennzeichnet , daß**
die leitende Schicht (10) eine Polysiliziumschicht ist.

6. Verfahren nach Anspruch 5,
**dadurch gekennzeichnet , daß**
die Polysiliziumschicht (10) durch Oxidation in die zweite isolierende Schicht (22) umgewandelt wird.

7. Verfahren nach Anspruch 5,
**dadurch gekennzeichnet , daß**
die Polysiliziumschicht (10) in die zweite isolierende Schicht (22) umgewandelt wird, indem ein Teil der Polysiliziumschicht (10) entfernt und der verbleibende Teil durch Oxidation in eine Siliziumoxidschicht (22) umgewandelt wird.

8. Verfahren nach einem der Ansprüche 1 bis 7,
**dadurch gekennzeichnet , daß**
der Dotierstoff (15, 20) durch eine Implantation mit anschließender Wärmebehandlung in das Halbleitersubstrat (1) eingebracht wird.

9. Verfahren nach Anspruch 8,
**dadurch gekennzeichnet , daß**
der Dotierstoff (15, 20) durch die erhöhte Temperatur bei der Oxidation des Polysiliziums in das Halbleitersubstrat (1) eingetrieben wird.

10. Verfahren nach einem der Ansprüche 1 bis 9,
**dadurch gekennzeichnet , daß**
das erste und das zweite Gebiet (3, 5) jeweils Bereiche (32, 34) aufweisen, die für Substratkontakte vorgesehen sind,
daß die erste Maske (12) über den Bereichen (32) in dem zweiten Gebiet (5), die für Substratkontakte vorgesehen sind, Öffnungen aufweist und Bereiche (34) in dem ersten Gebiet (3), die für Substratkontakte vorgesehen sind, bedeckt, und
daß die zweite Maske (17) über den Bereichen (34) in dem ersten Gebiet (3), die für Substratkontakte vorgesehen sind, Öffnungen aufweist und Bereiche (32) in dem zweiten Gebiet (5), die für Substratkontakte vorgesehen sind, bedeckt.

11. Verfahren nach einem der Ansprüche 1 bis 10,
**dadurch gekennzeichnet , daß**
in den vorgegebenen Gebieten (3, 5), in denen die zu erzeugenden Transistoren angeordnet werden sollen, Isolationszonen (6), insbesondere Locos-Isolationen oder Shallow-Trench-Isolationen, vorgesehen sind, die die Transistoren begrenzen.

## Claims

1. Method for fabricating a semiconductor component having a wiring which runs at least piecewise in the substrate, at least one conductive connection (24) running in the semiconductor substrate and at least one conductive connection (14, 18) running on the semiconductor substrate (1) being provided and the method being adapted to a method for fabricating at least two MOS transistor types, having the following steps:
a) a semiconductor substrate (1) is provided, which has at least one first zone (3) of a second conductivity type for the transistors of the first transistor type and a second zone (5) of a first conductivity type for the transistors of the second transistor type,
b) a first insulating layer (8) is applied to the semiconductor substrate (1),
c) a dopant of the first conductivity type is introduced into the first zone (3) into the region of a later crossover point between the conductive connection (24) running in the semiconductor substrate and the conductive connection (14) running on the semiconductor substrate (1), and/or a dopant of the second conductivity type is introduced into the second zone (5) into the region of a later crossover point between the conductive connection (24) running in the semiconductor substrate and the conductive connection (18) running on the semiconductor substrate (1),
d) a conductive layer (10) is applied to the first insulating layer (8),
e) a first mask (12) is applied by means of a phototechnology, which mask covers the second zone (5) virtually completely and, in the first zone (3), essentially only the gate tracks of the transistors of the first transistor type that are to be produced and also, if appropriate, the conductive connection (14) running on the semiconductor substrate (1),
f) said first mask (12) is used to convert the conductive layer (10) into a second insulation layer (22), or to remove it, and to introduce at least one dopant (15) of the first conductivity type into the semiconductor substrate (1),
g) a second mask (17) is applied by means of a phototechnology, which mask covers the first zone (3) virtually completely and, in the second zone (5), essentially only the gate tracks of the transistors of the second transistor type that are to be produced and also, if appropriate, the conductive connection (18) running on the semiconductor substrate (1),
h) said second mask (17) is used to convert the conductive layer (10) into a second insulation layer (22), or to remove it, and to introduce at least one dopant (20) of the second conductivity type into the semiconductor substrate (1),
i) by increasing the temperature, a conductive connection (24) running in the semiconductor substrate is produced by means of the dopants introduced in the region of the crossover points and the dopants introduced by means of the first and/or second mask.

2. Method according to Claim 1,
**characterized in that**
a region (19), which is not covered by both masks (12, 17), is provided between the first and second zones (3, 5).

3. Method according to either of Claims 1 and 2,
**characterized in that**
a protective layer (11) is applied to the conductive layer (10) and is removed after the application of the mask(s) (12, 17) in accordance with the mask(s) (12, 17).

4. Method according to Claim 3,
**characterized in that**
the protective layer (11) is an oxide-nitride-oxide layer.

5. Method according to one of Claims 1 to 4,
**characterized in that**
the conductive layer (10) is a polysilicon layer.

6. Method according to Claim 5,
**characterized in that**
the polysilicon layer (10) is converted by oxidation into the second insulating layer (22).

7. Method according to Claim 5,
**characterized in that**
the polysilicon layer (10) is converted into the second insulating layer (22) by part of the polysilicon layer (10) being removed and the remaining part being converted by oxidation into a silicon oxide layer (22).

8. Method according to one of Claims 1 to 7,
**characterized in that**
the dopant (15, 20) is introduced into the semiconductor substrate (1) by means of implantation with subsequent thermal treatment.

9. Method according to Claim 8,
**characterized in that**
the dopant (15, 20) is driven into the semiconductor substrate (1) by the elevated temperature during the oxidation of the polysilicon.

10. Method according to one of Claims 1 to 9,
**characterized in that**
the first and the second zone (3, 5) each have regions (32, 34) provided for substrate contacts,
the first mask (12) has openings above the regions (32) in the second zone (5) which are provided for substrate contacts, and covers regions (34) in the first zone (3) which are provided for substrate contacts, and
the second mask (17) has openings above the regions (34) in the first zone (3) which are provided for substrate contacts, and covers regions (32) in the second zone (5) which are provided for substrate contacts.

11. Method according to one of Claims 1 to 10,
**characterized in that**
in the predetermined zones (3, 5) in which the transistors to be produced are intended to be arranged, insulation zones (6), in particular Locos isolations or shallow trench isolations, are provided, which delimit the transistors.

## Revendications

1. Procédé de production d'un composant à semi-conducteur ayant un câblage s'étendant au moins par tronçons dans le substrat, au moins une liaison (24) conductrice s'étendant dans le substrat semi-conducteur, et au moins une liaison (14, 18) conductrice s'étendant sur le substrat (11) semi-conducteur étant prévues, et le procédé étant adapté à un procédé de production d'au moins deux types de transistors MOS ayant les stades suivants :
a) on se procure un substrat (1) semi-conducteur qui a au moins une première zone (3) d'un deuxième type de conductivité pour les transistors du premier type de transistor et une deuxième zone (5) d'un premier type de conductivité pour les transistors du deuxième type de transistor,
b) on dépose sur le substrat (1) semi-conducteur une première couche (8) isolante,
c) on introduit une substance de dopage du premier type de conductivité dans la première zone (3) dans la partie d'un point d'intersection ultérieur entre la liaison (24) conductrice s'étendant dans le substrat semi-conducteur et la liaison (14) conductrice s'étendant sur le substrat (1) semi-conducteur et/ou on introduit une substance de dopage du deuxième type de conductivité dans la deuxième zone (5) dans la partie d'un point d'intersection ultérieur entre la liaison (24) conductrice s'étendant dans le substrat semi-conducteur et la liaison (18) conductrice s'étendant sur le substrat (1) semi-conducteur,
d) on dépose une couche (10) conductrice sur la première couche (8) isolante,
e) on dépose, au moyen d'une technique photographique, un premier masque (12) qui recouvre la deuxième zone (5) à peu près complètement et, dans la première zone (3), essentiellement seulement les pistes de grille des transistors à produire du premier type de transistor, ainsi que, le cas échéant, la liaison (14) conductrice s'étendant sur le substrat semi-conducteur,
f) on utilise ce premier masque (12) pour transformer la couche (10) conductrice en une deuxième couche (22) isolante ou pour l'éliminer, et on introduit au moins une substance (15) de dopage du premier type de conductivité dans le substrat (1) semi-conducteur,
g) on dépose, au moyen d'une technique photographique, un deuxième masque (17) qui recouvre la première zone (3) presque complètement et, dans la deuxième zone (5), sensiblement seulement les pistes de grille du transistor à produire du deuxième type de transistor, ainsi que le cas échéant la liaison (18) conductrice s'étendant sur le substrat (1) semi-conducteur,
h) on utilise ce deuxième masque (17) pour transformer la couche (10) conductrice en une deuxième couche (22) isolante ou pour l'éliminer, et on introduit au moins une substance (20) de dopage du deuxième type de conductivité dans le substrat (1) semi-conducteur,
i) en élevant la température, on produit, par la substance de dopage introduite dans la partie des points d'intersection et par la substance de dopage introduite au moyen des premier et deuxième masques, une liaison (24) conductrice s'étendant dans le substrat semi-conducteur.

2. Procédé suivant la revendication 1,
**caractérisé en ce que** l'on prévoit, entre la première et la deuxième zone (3, 5), une partie qui n'est pas recouverte par les deux masques (12, 17).

3. Procédé suivant l'une des revendications 1 ou 2,
**caractérisé en ce que** l'on dépose sur la couche (10) conductrice une couche (11) de protection qui, après le dépôt du (des) masque(s) (12, 17), est éliminée conformément au(x) masque(s) (12, 17).

4. Procédé suivant la revendication 3,
**caractérisé en ce que** la couche (11) de protection est une couche d'oxyde-nitrure-oxyde.

5. Procédé suivant l'une des revendications 1 à 4,
**caractérisé en ce que** la couche (10) conductrice est une couche de polysilicium.

6. Procédé suivant la revendication 5,
**caractérisé en ce que** l'on transforme la couche (10) de polysilicium en la deuxième couche (22) isolante par oxydation.

7. Procédé suivant la revendication 5,
**caractérisé en ce que** l'on transforme la couche (10) de polysilicium en la deuxième couche (22) isolante, en éliminant une partie de la couche (10) de polysilicium et en transformant la partie restante en une couche (22) d'oxyde de silicium par oxydation.

8. Procédé suivant l'une des revendications 1 à 7,
**caractérisé en ce que** l'on introduit la substance (15, 20) de dopage dans le substrat (1) semi-conducteur par une implantation suivie d'un traitement thermique.

9. Procédé suivant la revendication 8,
**caractérisé en ce que** l'on introduit la substance (15, 20) de dopage dans le substrat (1) semi-conducteur en élevant la température lors de l'oxydation du polysilicium.

10. Procédé suivant l'une des revendications 1 à 9,
**caractérisé en ce que**
la première et la deuxième zone (3, 5) ont respectivement des parties (32, 34) qui sont prévues pour des contacts de substrat,
**en ce que** le premier masque (12) a des ouvertures au-dessus des parties (32) de la deuxième zone (5), qui sont prévues pour des contacts de substrat, et recouvre des parties (34) de la première zone (3), qui sont prévues pour des contacts de substrat, et
**en ce que** le deuxième masque (17) a des ouvertures au-dessus des parties (34) de la première zone (3), qui sont prévues pour des contacts de substrat, et recouvre des parties (32) de la deuxième zone (5), qui sont prévues pour des contacts de substrat.

11. Procédé suivant l'une des revendications 1 à 10,
**caractérisé en ce que**, dans les zones (3, 5) prescrites dans lesquelles il faut mettre les transistors à produire, on prévoit des zones (6) isolantes, notamment des isolations locos ou des isolations shallow-trench, qui délimitent les transistors.
